# EUROPEAN PATENT APPLICATION

(11) **EP 4 686 980 A1**
(43) Date of publication of application: **04.02.2026**
(21) Application number: 24191697.2
(22) Date of filing: 30.07.2024
(51) Int. Cl.: G03F 7/20

(54) **EXPOSURE APPARATUS AND EXPOSURE METHOD**

(71) Applicant: ASML Netherlands B.V., 5500 AH Veldhoven (NL)
(72) Inventor: VAN DRENT, William, Peter, 5500 AH Veldhoven (NL); MCNAMARA, John, Martin, 5500 AH Veldhoven (NL); SLACHTER, Abraham, 5500 AH Veldhoven (NL); OVERKAMP, Jim, Vincent, 5500 AH Veldhoven (NL); CASTENMILLER, Thomas, Josephus, Maria, 5500 AH Veldhoven (NL); GANG, Tian, 5500 AH Veldhoven (NL)
(74) Representative: ASML Netherlands B.V.

(57) **Abstract**

An exposure apparatus comprises a first object support configured to support a first object (e.g. a reticle) and a second object support configured to support a second object (e.g. a reticle). The first and second object supports are movable relative to an illumination region. In some embodiments, imaging optics of the exposure apparatus may be anamorphic (i.e. having a reduction factor of the image(s) that is different in two different directions. In some embodiments, a gap between the first object support and the second object support may be sufficiently small that a single object may be partially supported by the first object support and partially supported by the second object support. An exposure method is disclosed in which an image is formed of each of two objects (reticles) during a single scanning exposure process.

## Description

### FIELD

The present invention relates to an exposure apparatus. The exposure apparatus may comprise a lithographic apparatus. In particular, the lithographic apparatus may comprise an extreme ultraviolet (EUV) lithographic apparatus. The exposure apparatus may be a scanning exposure apparatus. The present invention also relates to an exposure method (which may be carried out using the exposure apparatus).

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In general, a lithographic apparatus may be used to form a pattern on a plurality of target regions of a substrate. For example, a lithographic apparatus may be used to form the same pattern on a plurality of target regions (also referred to as fields) of a resist-coated silicon wafer. The pattern is typically defined by a patterning device (also referred to as a reticle or mask). Radiation is patterned by the reticle and then imaging optics are used to form an image of the pattern on the wafer. EUV lithographic reticles are typically reflective optical elements provided with a patterned coating that absorbs EUV radiation. The wafer may then be moved and the image can be formed on another field of the wafer and so on. The pattern may be transferred to the wafer during a scanning exposure in which the reticle is scanned through an illumination region (also referred to as a slit) while the wafer is also moved such that the image of the reticle is stationary with respect to the wafer.

It may be desirable to provide new exposure apparatus and/or exposure methods that improve existing arrangements. For example, it may be desirable to provide new exposure apparatus and/or exposure methods that improves throughput and/or accuracy relative to such existing arrangements. Additionally or alternatively, it may be desirable to provide new exposure apparatus and/or exposure methods that at least partially address one or more problems associated with existing arrangements whether such problems are identified herein or otherwise.

### SUMMARY

According to a first aspect of the present disclosure there is provided an exposure apparatus comprising: a main support; a first object support configured to support a first object and movable relative to the main support so that the first object is movable relative to a first illumination region; a second object support configured to support a second object and movable relative to the main support so that the second object is movable relative to the first illumination region; and imaging optics configured to form an image of the first illumination region in a second illumination region; wherein the first object support is movable relative to the second object support and/or the second object support is movable relative to the first object support; wherein the first object support is offset from the second object support in a first direction; and wherein the imaging optics is anamorphic such that a reduction factor of the image in the first direction is greater than a reduction factor of the image in a second direction that is generally perpendicular to the first direction.

The first object support and/or the second object support may be configured to support any type of patterning device (also referred to as a reticle or mask). The first object support and/or the second object support may comprise any type of reticle stage.

The exposure apparatus may comprise a lithographic apparatus (for example an EUV lithographic apparatus). The exposure apparatus may be a scanning exposure apparatus. A lithographic apparatus may be used to form a pattern on a plurality of target regions of a substrate. For example, a lithographic apparatus may be used to form the same pattern on a plurality of target regions (also referred to as fields) of a resist-coated silicon wafer. The pattern is typically defined by a patterning device (also referred to as a reticle or mask). Radiation is patterned by the reticle and then imaging optics are used to form an image of the pattern on the wafer. EUV lithographic reticles are reflective optical elements provided with a patterned coating that absorbs EUV radiation. The wafer may then be moved and the image can be formed on another field of the wafer and so on.

The pattern may be transferred to the wafer during a scanning exposure in which the reticle is scanned through an illumination region (also referred to as a slit) while the wafer is also moved such that the image of the reticle is stationary with respect to the wafer.

Within the lithographic field, reticles are expensive to manufacture. Reticles are typically formed from a reticle blank and reticle blanks are typically of a standard size (referred to as a 6" reticle blank). A first generation of EUV lithographic apparatus (also referred to as scanners) used spherical imaging optics with a reduction factor of 4 to form an image of a reticle (formed from a standard 6" reticle blank) that was reduced in both dimensions by the factor of 4. In order to increase the resolution of EUV lithography, the imaging optics of the next generation of EUV lithographic apparatus will have an increased numerical aperture (NA). Since EUV reticles are reflective, the EUV radiation is not normal to the reticle but rather is incident at a non-zero angle to a normal of the reticle in one direction (so that the incoming cone of radiation that is incident on the reticle is separate from the outgoing cone of radiation scattered by the reticle and which is accepted by the imaging optics). This direction is typically the scanning direction of the lithographic apparatus. In this direction, there is a limit the extent to which the cone of radiation of the incoming radiation can be enlarged without overlapping the scattered cone of radiation (unless the angle of incidence of the chief ray of the incoming radiation is increased). However, it is undesirable to increase the angle of incidence of the chief ray of the incoming radiation as this will increase 3D effects of the reticle, reducing contrast. Therefore, it has been proposed to use anamorphic imaging optics in the next generation of EUV lithographic apparatus such that, in the scanning direction, the reduction factor of the imaging optics is 8 whereas in the non-scanning direction the reduction factor remains 4 and the cone of light is enlarged only in the non-scanning direction.

However, one consequence of the increased reduction factor is that the field of view that can be imaged with a standard 6" reticle is now halved.

It may be desirable to form a pattern that is larger than the size of existing reticles (especially in the next generation of EUV lithographic apparatus using anamorphic imaging optics). Therefore, in some systems, each target region (field) may be exposed using two reticles, each of which defines the pattern of half of the field. However, such a half-field design increases the number of field-steps that need to be taken in order to expose the entire wafer and therefore reduces the throughput of the lithographic apparatus as compared to a full-field system (in which the pattern of the entire field is defined by a single reticle). By default, the wafer is exposed in two steps and a (slow) reticle swap is performed in between. This further reduces throughput of the system. The second exposure with the second reticle can be done in at least two different ways. A first method involves keeping the wafer on a wafer stage once each field has been exposure using the first reticle, exchanging the reticle and exposing the wafer for the second time. However, this is very slow. A second method involves exposing a whole lot of wafers (e.g. 25 wafers) with one reticle, exchanging the reticle and then involves exposing the whole lot of wafers again. This can increase the throughput relative to the first method, however, it also has some disadvantages. For example, since the wafer is clamped to the wafer stage twice there is some additional time overhead in the time taken to swap wafers and, once a new wafer has been positioned on the wafer stage, the time taken to align the wafer. In addition, with the second method the wafer is clamped on the wafer stage for less time each time, which can limit the available time for measurements to be made once the wafer has been clamped and before it is exposed (without again negatively impacting the lithographic throughout). For example, the available measurement time may be reduced by a factor of 2 since only half the amount of fields are exposed per wafer pass. As a consequence, the number of alignment marks that can be measured is halved. In addition, a buffer (also referred to as a stocker) may be required to temporarily store the entire lot of wafers in between the first and second exposures.

Advantageously, by providing both a first object support and a second object support two objects (reticles) may be provided in the lithographic apparatus at the same time. This can allow for the reticle to be effectively swapped very quickly by simply moving the first object support and the second object support so as to position a different reticle in the illumination region (slit). Furthermore, this allows for each wafer to be exposed using both reticles with no (or a negligible) loss of throughput whilst the same amount of time is available for measurements of the wafer once the wafer has been clamped and before it is exposed as would be available for a full-field system.

Furthermore, allowing the first object support to be movable relative to the second object support is particularly advantageous as it allows for two objects (reticles) to be accommodated while minimizing the volume required for the two object supports, as now discussed.

It will be appreciated that in order to accurately print features on a wafer of a desired critical dimension (for example of the order of 10 nm) the position of the wafer needs to controlled with greater precision than said critical dimension. A similar accuracy is required for the position of the reticle (although the accuracy may be relaxed by a factor equal to a reduction factor of the imaging optics). However, the accuracy with which a reticle can be positioned and orientated relative to a reticle stage may be significantly less that the desired critical dimension. For example, the accuracy with which a reticle can be positioned and orientated relative to a reticle stage may be of the order of 10-100 µm. Therefore, the reticle stage itself should be accurately controlled to allow for any inaccuracy of the position or orientation of the reticle.

When two reticles are provided in a lithographic apparatus, the position and orientation of each reticle relative to a stage to which it is clamped will, in general, be different. Allowing the first object support to be movable relative to the second object support allows for the reticles to be moved relative to each other once each one is clamped to a different one of the object supports. Advantageously, this may provide the adjustability to allow the position and/or the orientation of the two reticles to be controlled with sufficient accuracy that, for at least part of the exposure process, the two reticles can both partially overlap the illumination region simultaneously. This allows the two reticles to be provided arbitrarily close to each other (for example in a scanning direction of the lithographic apparatus). This is advantageous as the available volume for reticle stages in lithographic apparatus (especially an EUV lithographic apparatus which uses reflective reticles) may be limited.

The first object support may be movable relative to the second object support and/or the second object support may be movable relative to the first object support such that a relative position of the first and second object supports is controllable in 6 degrees of freedom.

For example, these 6 degrees of freedom may comprise three translational degrees of freedom (x, y and z) and three rotational degrees of freedom (Rx, Ry, Rz).

According to a second aspect of the present disclosure there is provided an exposure apparatus comprising: a main support; a first object support configured to support a first object and movable relative to the main support; and a second object support configured to support a second object and movable relative to the main support; wherein a gap between the first object support and the second object support is sufficiently small that a single object may be partially supported by the first object support and partially supported by the second object support.

The first object support and/or the second object support may be configured to support any type of patterning device (also referred to as a reticle or mask). The first object support and/or the second object support may comprise any type of reticle stage.

The exposure apparatus may comprise a lithographic apparatus (for example an EUV lithographic apparatus). The exposure apparatus may be a scanning exposure apparatus. A lithographic apparatus may be used to form a pattern on a plurality of target regions of a substrate. For example, a lithographic apparatus may be used to form the same pattern on a plurality of target regions (also referred to as fields) of a resist-coated silicon wafer. The pattern is typically defined by a patterning device (also referred to as a reticle or mask). Radiation is patterned by the reticle and then imaging optics are used to form an image of the pattern on the wafer. EUV lithographic reticles are reflective optical elements provided with a patterned coating that absorbs EUV radiation. The wafer may then be moved and the image can be formed on another field of the wafer and so on. The pattern may be transferred to the wafer during a scanning exposure in which the reticle is scanned through an illumination region (also referred to as a slit) while the wafer is also moved such that the image of the reticle is stationary with respect to the wafer.

The exposure apparatus according to the second aspect of the present disclosure is advantageous since to allows (a) for two separate objects (reticles) to be supported, one by each of the first and second object supports or (b) a single object (for example a larger than standard reticle) to be supported by the two object supports together. Therefore, the exposure apparatus according to the second aspect of the present disclosure provides a particularly versatile arrangement.

As with the exposure apparatus of the first aspect, the first object support may be offset from the second object support in a first direction. As with the exposure apparatus of the first aspect, the exposure apparatus of the second aspect may comprise imaging optics configured to form an image of the first illumination region 150 in a second illumination region. The imaging optics may be anamorphic such that a reduction factor of the image in the first direction may be greater than a reduction factor of the image in a second direction that is generally perpendicular to the first direction.

The first object support of the exposure apparatus according to the second aspect of the present disclosure may be movable relative to the second object support and/or the second object support may be movable relative to the first object support.

The first object support and the second object support of the exposure apparatus according to the first or second aspects of the present disclosure may be provided such that a gap between them in a direction in which the first object support is offset from the second object support is less than 400 µm.

In some embodiments, the first object support and the second object support may be provided such that, in use, a gap between an imaging portion of a first object supported by the first object support and an imaging portion of a second object supported by the second object support in a direction in which the first object support is offset from the second object support is less than 400 µm.

Typically the scribe lanes in a silicon wafer that separate adjacent fields or target regions have a dimension of the order of 50 µm on the wafer. Therefore, with a reduction factor of 8 in the direction in which the first object support is offset from the second object support, at reticle level the scribe lane between two adjacent fields in this direction will be of the order of 400 µm. Therefore, by ensuring that the first object and the second object are provided such that a gap between them in the direction in which the first object support is offset from the second object support is less than 400 µm, the gap between the first and second objects can fall within a scribe lane.

The first object support and/or the second object support of the exposure apparatus according to the first or second aspect of the present disclosure may comprise an electrostatic clamp. In some embodiments, the exposure apparatus may comprise a single electrostatic clamp, which may form part of the first object support and part of the second object support.

The exposure apparatus according to the first or second aspect of the present disclosure may comprise a long stroke assembly comprising a first portion that is fixed relative to the main support and a second portion that is movable relative to the first portion and which supports the first object support and the second object support.

The long stroke assembly may allow for the first and second object supports to be moved relative to the first illumination region over distances of the order of 10s or 100s of millimetres.

The long stroke assembly may further comprise a balance mass. The balance mass may be movable relative to the first portion of the long stroke assembly. In use, the balance mass and the first portion of the long stroke assembly may move in an opposite sense to each other.

The exposure apparatus according to the first or second aspects of the present disclosure may further comprising at least one short stroke assembly comprising a first portion that is fixed relative to second portion of the long stroke assembly and a second portion that is movable relative to the first portion and which supports the first object support and/or the second object support.

Some embodiments may comprise two short stroke assemblies; a first short stroke assembly may support the first object support and a second short stroke assembly may support the second object support. Alternatively, in some embodiments, two reticles may be supported by a single short stroke assembly (but via separate reticle clamps). For such embodiments, at least one of the clamps may comprise actuators (for example piezoelectric actuators) configured to allow the first object support to be movable relative to the second object support (for example in 6 degrees of freedom).

The exposure apparatus according to the second aspect of the present disclosure may further comprise imaging optics configured to form an image of a first illumination region in a second illumination region. Said imaging optics may be anamorphic such that a reduction factor of the image in the first direction is greater than a reduction factor of the image in a second direction that is generally perpendicular to the first direction.

A reduction factor of the image formed by the imaging optics of the exposure apparatus according to the first or second aspect of the present disclosure in the direction in which the first object support is offset from the second object support may be 8 and a reduction factor of said image in a second direction that is generally perpendicular to the first direction may be 4.

The exposure apparatus according to the first or second aspect of the present disclosure may further comprise illumination optics configured to illuminate with radiation a first illumination region through which an object supported by the first object support and/or the second object support can be moved.

The exposure apparatus according to the first or second aspect of the present disclosure may further comprise a radiation source operable to produce the radiation.

The radiation may comprise EUV radiation. The radiation source may comprise a laser-produced plasma (LPP) radiation source.

The exposure apparatus according to the first or second aspect of the present disclosure may further comprise a controller operable to carry out the exposure method according to the third aspect of the present disclosure.

According to a third aspect of the present disclosure there is provided an exposure method for forming a pattern on a plurality of target regions of a substrate, the exposure method comprising: providing a first object defining a first portion of the pattern and a second object defining a second portion of the pattern, such that the first object is adjacent to, and generally coplanar with, the second object, the first object offset from the second object in a first direction; and at least one scanning exposure, the or each scanning exposure comprising: moving the first object and the second object in the first direction such that they sequentially scan through a first illumination region while providing radiation to the first illumination region; and capturing radiation scattered by the first and second objects and using it to form an image of the first and second objects in a second illumination region while moving the substrate through the second illumination region such that an image of the first object is formed on a first target region of the substrate and an image of the second object is formed on a second target region of the substrate, the first and second target regions being mutually adjacent.

The exposure method according to the third aspect may be carried out using the exposure apparatus of the first or second aspects of the present disclosure.

The exposure method according to the third aspect of the present disclosure may comprise a lithographic exposure method. The first object and the second object may comprise any type of patterning device (also referred to as a reticle or mask). The first illumination region may be disposed in an object plane (which may also referred to as a reticle-level illumination region). The second illumination region may be disposed in an image plane (which may also referred to as a wafer-level illumination region). The first and/or second illumination region may be referred to as a slit (or exposure slit).

Instead of exposing two half-fields separately as two different steps, with the exposure method of the third aspect both reticles are exposed in a single stroke. An image of the first object (reticle) is formed on a first target region (field) of the substrate and an image of the second object

(reticle) is formed on a second target region (field) of the substrate, the first and second target regions being mutually adjacent. The area in-between these two images is matched to fall within the scribe line area of the wafer.

The first object and the second object may be provided such that a gap between them in the first direction is less than an extent of the first illumination region in the first direction.

The first object and the second object may be provided such that for at least a portion of the or each scanning exposure the first and second objects are both partially disposed in the first illumination region in the first direction.

The first object and the second object may be provided such that a gap between them in the first direction is less than 400 µm.

The method may comprise a plurality of scanning exposures and the plurality of scanning exposures may be performed as a meander scan.

The method may comprise a plurality of scanning exposures and the image of the first object formed on a target region of the substrate during one scanning exposure may be stitched to the image of the second object formed on that target region of the substrate during another scanning exposure.

The images of the first object and the second object that are stitched may be mutually adjacent in the first direction.

That is, the two images that are stitched are mutually adjacent in the scanning direction. Put differently, a join line between the two images that are stitched extends in a second direction (a non-scanning direction).

Another benefit of the embodiments of the present disclosure is that they will, in general, result in less reticle heating than prior art arrangements. This is because the reticle heating load is divided between two reticles and therefore the heat load is divided by a factor of 2. Furthermore, the embodiments of the present disclosure will, in general, result in less particle defectivity as the wafers are not stored in a stocker (since the wafers are only exposed once).

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A is a schematic representation of a single target region of a wafer, showing both: (a) a shape of the target region; and (b) a shape of a wafer-level illumination region;
- Figure 2B schematically shows two adjacent target regions of a wafer which are exposed sequentially using two opposite scan directions; these two consecutive exposures may form part of a meander scan, for example a meander scan of the type shown in Figure 3;

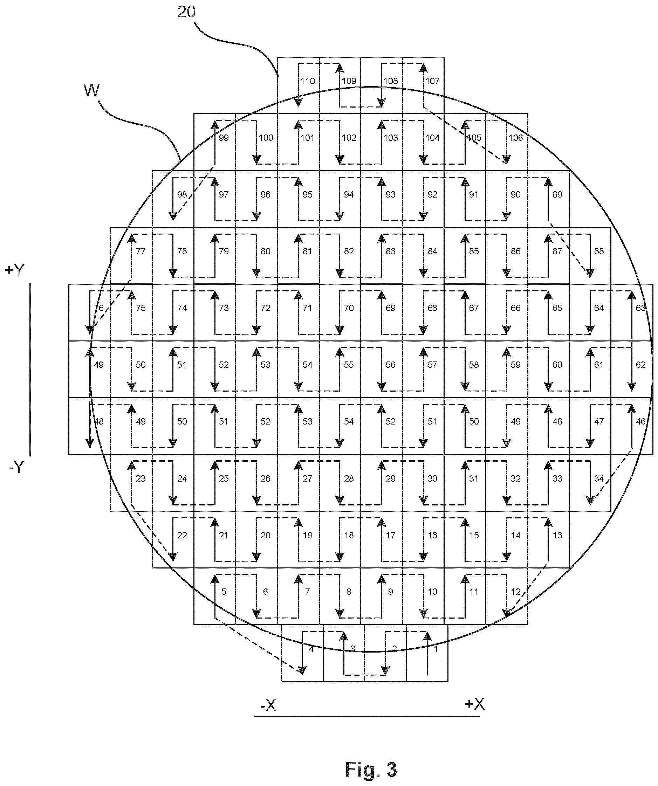

- Figure 3 is a schematic plan view representation of a (generally circular) substrate comprising a plurality of (generally rectangular) target regions or dies; also shown is a standard meander scan pattern in which each row of target regions (extending in a non-scanning direction) is exposed in turn, with the order of the exposure of the target regions indicated by a number on each target region, the scanning direction of the exposure of each target region is indicated by a solid arrow and the movement of the substrate in between exposure of two consecutive target regions is indicated by dashed lines;
- Figure 4 is a schematic representation of a first new exposure apparatus according to the present disclosure;
- Figure 5A is a schematic representation of a second new exposure apparatus according to the present disclosure supporting two objects;
- Figure 5B is a schematic representation of the second new exposure apparatus according to the present disclosure as shown in Figure 5A but supporting a single object;
- Figure 6A schematically shows a first arrangement, which may form part of the first new exposure apparatus shown in Figures 4 or the second new exposure apparatus shown in Figures 5A and 5B, comprising a long stroke assembly and two short stroke assemblies;
- Figure 6B schematically shows a second arrangement, which may form part of the first new exposure apparatus shown in Figures 4 or the second new exposure apparatus shown in Figures 5A and 5B, comprising a long stroke assembly and a single short stroke assembly;
- Figure 7A shows a possible actuation pattern for the electrodes of the arrangements shown in Figures 6A and 6B when the first and second object supports are each supporting a different object (reticle);
- Figure 7B shows a possible actuation pattern for the electrodes of the arrangements shown in Figures 6A and 6B when only one of the first and second object supports is supporting an object (reticle);
- Figure 7C shows a first possible actuation pattern for the electrodes of the arrangements shown in Figures 6A and 6B when the first and second object supports are together supporting a single object (reticle);
- Figure 7D shows a second possible actuation pattern for the electrodes of the arrangements shown in Figures 6A and 6B when the first and second object supports are together supporting a single object (reticle);
- Figure 8 shows an arrangement wherein, for at least part of an exposure process using the first new exposure apparatus shown in Figures 4 or the second new exposure apparatus shown in Figures 5A and 5B, two objects (reticles) both partially overlap the a first illumination region simultaneously;
- Figure 9 schematically illustrates an example exposure method and shows six target regions (solid line rectangles) arranged in a two-dimensional array of two rows (extending in the non-scanning or x-direction) and three columns (extending in the scanning or y-direction); each target region comprises two portions: a first portion (labelled A and on a lower half of the target regions as shown in Figure 8); and a second portion (labelled B and on an upper half of the target regions as shown in Figure 8); and
- Figure 10 is a schematic representation of a new exposure method according to an embodiment of the present disclosure for forming a pattern on a plurality of target regions of a substrate W.

### DETAILED DESCRIPTION

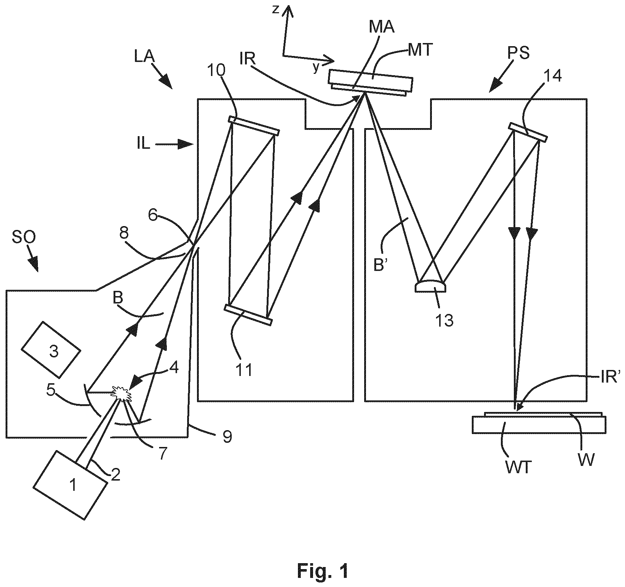

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W. The support structure MT may also be referred to as the reticle stage MT. The substrate table WT may also be referred to as the wafer stage WT.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA may be operable to align the image formed by the patterned EUV radiation beam B' with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred to as a reticle-level or object-level illumination region IR. The reticle-level illumination region IR may be referred to as a first illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit. The wafer-level illumination region IR' may be referred to as a second illumination region IR.

The lithographic apparatus LA may be a scanning lithographic apparatus (also referred to as a scanner) and the image (of a reticle MA) may be formed during a scanning exposure. In such an exposure, the reticle MA may be moved in a scanning direction through the reticle-level illumination region IR. It will be appreciated that, as a result of this movement of the reticle MA, the image of the reticle MA will move at wafer level. Therefore, during the scanning exposure, the wafer W is also moved through the wafer-level illumination region IR'. In particular, the wafer W is moved so that the image of reticle MA is substantially static with respect to the wafer W. The movement of the reticle MA and the substrate W are therefore synchronized. The movement (speed and direction) of the substrate W will be dependent on the movement of the reticle and the imaging performed by the projection system PS. In some embodiments, the projection system PS may form an inverted image of the reticle MA and therefore the substrate W may be moved in an opposite direction to the reticle MA. In some embodiments, the projection system PS may apply a reduction factor to the patterned EUV radiation beam B' in the scanning direction and therefore the substrate W may move at a speed that is smaller than the speed of the reticle MA by this reduction factor.

The lithographic apparatus LA may be of a type having two or more substrate supports WT (also named "dual stage" or "multiple stage" machines). In such multiple stage machine, the substrate supports WT may be used in parallel, and/or steps in preparation of a subsequent exposure of the substrate W may be carried out on the substrate W located on one of the substrate support WT while another substrate W, on the other substrate support WT, is being used for exposing a pattern on the other substrate W.

For example in a dual stage machine, while an nth wafer is being exposed on one of the stages, an (n + 1)th wafer is disposed on the other stage and various measurements are made in order to improve the accuracy of the lithographic process. Such measurements may be referred to generally as a metrology step or stage. Such measurements include, for example, measurements of the positions of alignments marks (used to help ensure the image formed in the lithographic process is well aligned to previously formed process layers). Another example of such a measurement includes a measurement of a shape of the wafer W, for example, measured using a level-sensor (used dynamically during the subsequent exposure of that wafer to keep the surface of the wafer as close to a plane of best focus as possible).

In general, for the accuracy of the subsequent lithographic exposure, it is desirable to increase the number of measurements taken during the metrology stage. On the other hand, it is desirable to increase the throughput of the lithographic apparatus LA (i.e. the speed at which wafers are exposed, for example number of wafers per hour). In practice, in order to maximize throughput, the time available for the metrology stage is limited to the time taken to expose the previous wafer such that as soon as one wafer has been exposed the next wafer has already been measured and is ready to be exposed.

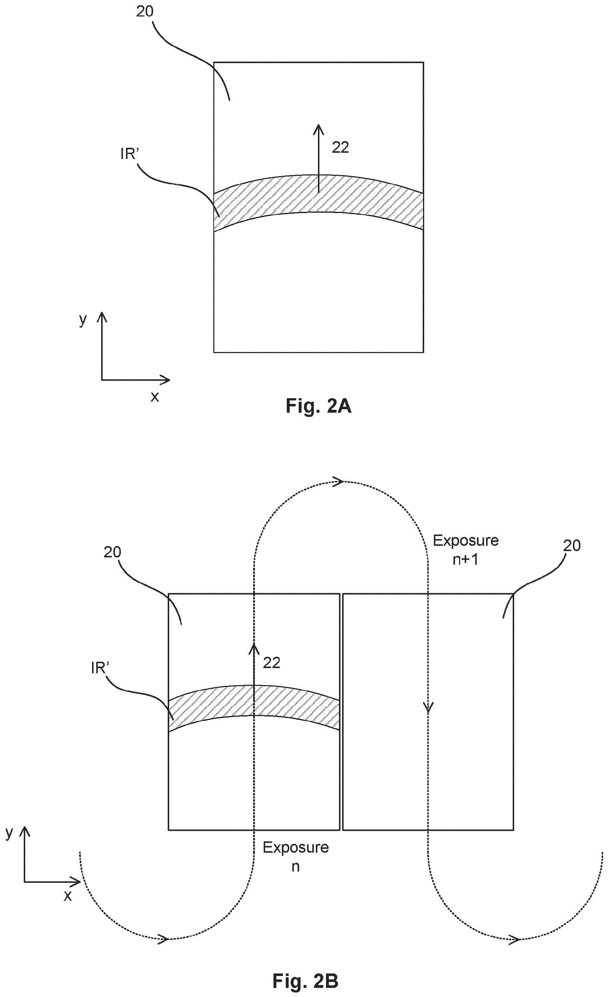

Figure 2A shows schematically a single target region 20 of a wafer W. A shape of the target region 20 is generally rectangular. Also shown in Figure 2A is the wafer-level illumination region IR' and a direction in which the wafer-level illumination region IR' effectively scans over the target region 20 is indicated by arrow 22. It will be appreciated that, in practice this may be achieved by scanning the target region 20 through the wafer-level illumination region IR' in a direction opposite to the arrow 22.

As shown in Figure 2B, in some known arrangements two adjacent target regions 20 may be exposed sequentially, as an nth exposure and an (n + 1)th exposure. The wafer W may be moved such that a direction in which the wafer-level illumination region IR' effectively scans over the target region 20 (indicated by dotted arrow 22) is in a first direction for the nth exposure and in an opposite direction for the (n + 1)th exposure. Such an arrangement may improve the throughput of the lithographic apparatus as this may minimize movements of the wafer W.

The arrangement shown in Figure 2B may form part of a meander scan, which is now described with reference to Figure 3. Figure 3 is a schematic plan view representation of a (generally circular) substrate W comprising a plurality of (generally rectangular) target regions 20 or fields. In the embodiment shown in Figure 15 the substrate W comprises 110 target regions 20. Each field may comprise a single die or multiple dies. For example, in some embodiments each field may comprise of the order of 4 to 25 dies.

Forming an image of a reticle MA on a substrate a plurality of times may comprise forming an image of the reticle MA on a plurality of target regions 20 of the substrate W. Each of the plurality of target regions 20 may be generally rectangular. The plurality of target regions 20 may be arranged as a two-dimensional array.

In some embodiments, the two-dimensional array of target regions 20 may be exposed using a standard meander scan pattern in which each row of target regions 20 (extending in a non-scanning direction; the x-direction in Figure 3) is exposed in turn. Such a standard meander scan pattern is illustrated in Figure 3, with the order of the exposure of the target regions 20 indicated by a number on each target region. The scanning direction 22 of the exposure of each target region 20 is indicated by a solid arrow and the movement of the substrate W in between exposure of two consecutive target regions 20 is indicated by dashed lines.

It will be appreciated by the skilled person that the speed and/or acceleration at which objects can be moved (for example the reticle MA and/or the wafer W) within the lithographic apparatus LA is determined by the mass and/or force and deformation limits of a support that supports them (for example a reticle stage MT or a wafer stage WT). Note that, in general, the reticle stage MT does not move in the non-scanning direction and only moves in the scanning direction whereas the wafer stage WT moves in both the scanning and non-scanning directions. Therefore, the reticle stage may be easier to design than the safer stage WT. It will also be appreciated that since the projection system PS may apply a reduction factor, in order for the reticle MA and the wafer W to move synchronously the reticle MA will, in general, experience greater speeds and accelerations that the wafer W.

In general, movement of a reticle MA is accomplished with a long stroke assembly and a short stroke assembly. The long stroke assembly allows the reticle to move (relative to a fixed frame) over distances of the order of 10s or 100s of millimetres. The short stroke assembly allows the reticle MA to be moved over small distance scales.

As used herein a short stroke assembly may comprise a chuck and a carrier. The chuck may house a clamp (for example an electrostatic clamp), encoders (position sensors) and the fiducials (marks that may be used for various measurements within the lithographic apparatus LA).

The clamp may comprise a glass structure (formed, for example, from ultra-low expansion glass or Zerodur glass), which supports the encoders and the fiducials. The glass structure may comprise three plates or layers. A first plate of the clamp faces the rear surface of the reticle (and may be provided with a plurality of protrusions or burls with the rear surface of the reticle contacting the distal ends of these burls). Between the first plate and a second plate are the electrodes. Between the second plate and a third plate may be water cooling. The third plate of the clamp may directly contact the chuck.

Some embodiments of the present disclosure relate to exposure apparatus (for example EUV lithography apparatus LA of the type shown in Figure 1 and described above) which can support two objects (for example reticles or patterning devices MA) simultaneously. For example, an EUV lithography apparatus LA may comprise a reticle stage that can support two reticles in series (i.e. side by side or adjacent each other). Alternatively, an EUV lithography apparatus LA may comprise two reticle stages that can each support a reticle such that the two reticles are adjacent each other and which can move synchronously. Some embodiments may comprise two short stroke assemblies: a first short stroke assembly arranged to support a first object support and a second short stroke assembly arranged to support a second object support. Alternatively, in some other embodiments, two reticles may be supported by a single short stroke assembly (via either one reticle clamp or two separate reticle clamps). For such embodiments, at least one of the clamps may comprise actuators (for example piezoelectric actuators) configured to allow first object support to be movable relative to the second object support (for example in 6 degrees of freedom).

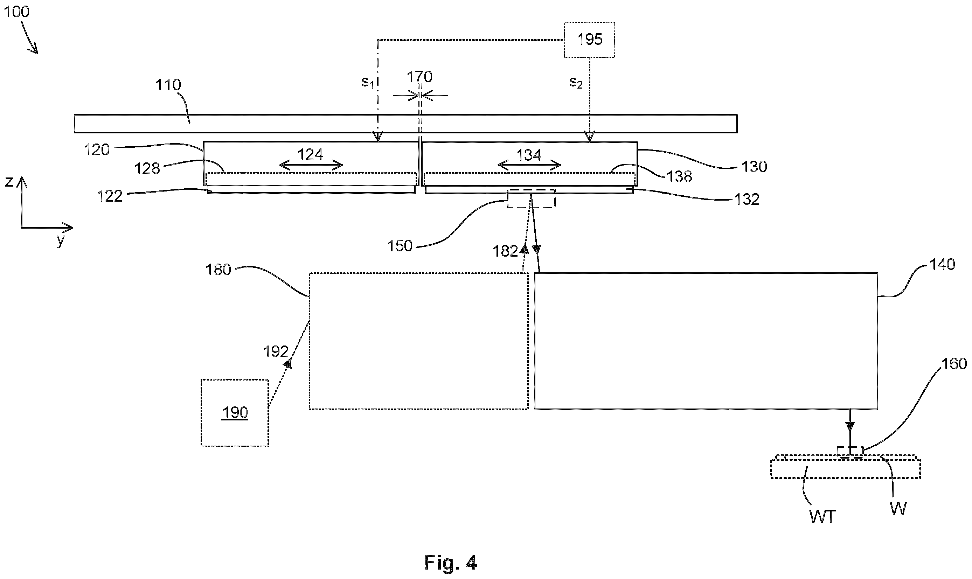

Figure 4 is a schematic representation of an exposure apparatus 100 according to an embodiment of the present disclosure. The exposure apparatus 100 comprises: a main support 110; a first object support 120; a second object support 130; and imaging optics 140. The exposure apparatus 100 may comprise a lithographic apparatus LA of the type shown in Figure 1 or a part or sub-component of such a lithographic apparatus LA.

The main support 110 may be considered to be a static portion of the exposure apparatus. For example, the main support 110 may comprise a frame which static parts of the exposure apparatus 100 are connected to. Alternatively, the main support 110 may comprise a body which is connected to such a frame.

The first object support 120 is configured to support a first object 122. As indicated by arrow 124, the first object support 120 is movable relative to the main support 110 so that the first object 122 is movable relative to a first illumination region 150. The first object 122 may comprise a reticle or mask MA. The first object support 120 may be generally of the form of a support structure MT (i.e. a reticle stage) of the type shown in Figure 1. The first illumination region 150 maybe generally equivalent to the reticle-level or object-level illumination region IR described above with reference to Figure 1.

The second object support 130 is configured to support a second object 132. As indicated by arrow 134, the second object support 130 is movable relative to the main support 110 so that the second object is movable relative to the first illumination region 150. The second object 132 may comprise a reticle or mask MA. The second object support 130 may be generally of the form of a support structure MT (i.e. a reticle stage) of the type shown in Figure 1.

The first object support 120 is offset from the second object support 130 in a first direction. In Figure 4 the first direction is labelled as the y-direction. As discussed further below, the first direction (y-direction) is a scanning direction of the exposure apparatus 100. Note that, as indicated by arrows 124, 134, the first object support 120 and second object support 130 are each movable relative to the main support 110 in the first direction (y-direction). The first object support 120 and second object support 130 may also be movable relative to the main support 110 in a second direction that is perpendicular the first direction (y-direction).

The imaging optics 140 is configured to form an image of the first illumination region 150 in a second illumination region 160. The imaging optics 140 may be generally analogous to the projection system PS shown in Figure 1 and as described above. The imaging optics 140 is anamorphic such that a reduction factor of the image in the first direction is greater than a reduction factor of the image in a second direction that is generally perpendicular to the first direction. In Figure 4 the second direction is into the page (and may be referred to as the x-direction).

The first object support 120 is movable relative to the second object support 130 and/or the second object support 130 is movable relative to the first object support 120. As discussed below, this has a number of advantages.

The first object support 120 and/or the second object support 130 may be configured to support any type of patterning device MA (also referred to as a reticle or mask). The first object support 120 and/or the second object support 130 may comprise any type of reticle stage MT.

The exposure apparatus 100 may comprise a lithographic apparatus (for example an EUV lithographic apparatus LA of the type shown in Figure 1). The exposure apparatus 100 may be a scanning exposure apparatus. A lithographic apparatus LA may be used to form a pattern on a plurality of target regions of a substrate. For example, a lithographic apparatus LA may be used to form the same pattern on a plurality of target regions (also referred to as fields) of a resist-coated silicon wafer W. The pattern is typically defined by a patterning device MA (also referred to as a reticle or mask). Radiation is patterned by the reticle MA and then imaging optics PS are used to form an image of the pattern on the wafer W. EUV lithographic reticles MA are reflective optical elements provided with a patterned coating that absorbs EUV radiation. The wafer W may then be moved and the image can be formed on another field of the wafer W and so on. As discussed above, the pattern may be transferred to the wafer W during a scanning exposure in which the reticle MA is scanned through an illumination region IR (also referred to as a slit) while the wafer W is also moved such that the image of the reticle is stationary with respect to the wafer W.

Within the lithographic field, reticles MA are expensive to manufacture. Reticles MA are typically formed from a reticle blank and reticle blanks are typically of a standard size (referred to as a 6" reticle blank). A first generation of EUV lithographic apparatus (also referred to as scanners) used spherical imaging optics PS with a reduction factor of 4 to form an image of a reticle (formed from a standard 6" reticle blank) that was reduced in both dimensions by the factor of 4.

In order to increase the resolution of EUV lithography, the imaging optics PS of the next generation of EUV lithographic apparatus will have an increased numerical aperture (NA). Since EUV reticles are reflective, the EUV radiation is not normal to the reticle MA but rather is incident at a non-zero angle to a normal of the reticle MA in one direction (so that the incoming cone of radiation B that is incident on the reticle MA is separate from the outgoing cone of radiation B' scattered by the reticle MA and which is accepted by the imaging optics PS). This direction is typically the scanning direction of the lithographic apparatus LA. In this direction, there is a limit the extent to which the cone of radiation of the incoming radiation B can be enlarged without overlapping the scattered cone of radiation B' (unless the angle of incidence of the chief ray of the incoming radiation B is increased). However, it is undesirable to increase the angle of incidence of the chief ray of the incoming radiation B as this will increase 3D effects of the reticle, reducing contrast and transmission. Therefore, it has been proposed to use anamorphic imaging optics PS in the next generation of EUV lithographic apparatus LA such that, in the scanning direction (e.g. the y-direction in Figure 1), the reduction factor of the imaging optics PS is 8 whereas in the non-scanning direction (e.g. the x-direction in Figure 1) the reduction factor remains 4 and the cone of light is enlarged only in the non-scanning direction.

However, one consequence of the increased reduction factor is that the field of view that can be imaged on the substrate W with a standard 6" reticle is now halved. That is, a single reticle can now only image half of the target region 20 shown, for example, in Figure 2A.

It may be desirable to form a pattern that is larger than the size of existing reticles (especially in the next generation of EUV lithographic apparatus using anamorphic imaging optics). Therefore, in some systems, each target region 20 (field) may be exposed using two reticles, each of which defines the pattern of half of the field. However, such a half-field design increases the number of field-steps that need to be taken in order to expose the entire wafer W and therefore reduces the throughput of the lithographic apparatus LA as compared to a full-field system (in which the pattern of the entire field 20 is defined by a single reticle). Such a full-field exposure process is described above with reference to Figures 2B and 3. With half-field exposures, by default, the wafer W is exposed in two steps and a (slow) reticle swap is performed in between. This further reduces throughput of the system. The second exposure with the second reticle can be done in at least two different ways. A first method involves keeping the wafer W on a wafer stage WT once each field 20 has been exposure using the first reticle, exchanging the reticle and exposing the wafer for the second time. However, this is very slow as it takes a significant amount of time to swap the reticles and align the new reticle. A second method involves exposing a whole lot of wafers (e.g. 25 wafers) with one reticle, exchanging the reticle and then involves exposing the whole lot of wafers again using a second reticle. This can increase the throughput relative to the first method, however, it also has some disadvantages. For example, since the wafer is clamped to the wafer stage twice there is some additional time overhead in the time taken to swap wafers and, once a new wafer has been positioned on the wafer stage, the time taken to align the wafer. In addition, with the second method the wafer is clamped on the wafer stage for less time each time, which can limit the available time for measurements to be made once the wafer has been clamped and before it is exposed (without again negatively impacting the lithographic throughout). For example, the available measurement time (for example for the next wafer that is clamped to another wafer stage) may be reduced by a factor of 2 since only half the amount of fields are exposed per wafer pass. As a consequence, the number of alignment marks that can be measured is halved. In addition, a buffer (also referred to as a stocker) may be required to temporarily store the entire lot of wafers in between the first and second exposures.

Advantageously, by providing both a first object support 120 and a second object support 130 two objects (reticles MA) may be provided in the lithographic apparatus LA at the same time. This can allow for the reticle MA to be effectively swapped very quickly by simply moving the first object support 120 and the second object support 130 so as to position a different reticle in the illumination region 150 (slit). Furthermore, this allows for each wafer W to be exposed using both reticles MA with no (or a negligible) loss of throughput whilst the same amount of time is available for measurements of the wafer W once the wafer W has been clamped and before it is exposed as would be available for a full-field system. As discussed above, in a dual stage machine, while an nth wafer is being exposed on one of the stages, an (n + 1)th wafer is disposed on the other stage and various measurements are made in order to improve the accuracy of the (subsequent) lithographic process. Such measurements may be referred to generally as a metrology step or stage. With the exposure apparatus 100 shown in Figure 4, the only additional time penalty relative to a full-field system is the (relatively small) additional time required to align two objects 122, 132 rather than just one.

Furthermore, allowing the first object support 120 to be movable relative to the second object support 130 is particularly advantageous as it allows for two objects (reticles MA) to be accommodated while minimizing the volume required for the two object supports 120, 130, as now discussed.

It will be appreciated that in order to accurately print features on a wafer of a desired critical dimension (for example of the order of 10 nm) the position of the wafer W needs to controlled with greater precision than said critical dimension. A similar accuracy is required for the position of the reticle MA (although the accuracy may be relaxed by a factor equal to a reduction factor of the imaging optics PS). However, the accuracy with which a reticle MA can be positioned and orientated relative to a reticle stage MT may be significantly less that the desired critical dimension. For example, the accuracy with which a reticle MA can be positioned and orientated relative to a reticle MT stage may be of the order of 10-100 µm. Therefore, the reticle stage MT itself should be accurately controlled to allow for any inaccuracy of the position or orientation of the reticle MA.

When two reticles MA are provided in a lithographic apparatus LA, the position and orientation of each reticle MA relative to a stage to which it is clamped will, in general, be different. Allowing the first object support 120 to be movable relative to the second object support 130 allows for the objects 122, 132 (reticles MA) to be moved relative to each other once each one is clamped to a different one of the object supports 120, 130. Advantageously, this may provide the adjustability to allow the position and/or the orientation of the two objects 122, 132 (reticles MA) to be controlled with sufficient accuracy that, for at least part of the exposure process, the two objects 122, 132 (reticles MA) can both partially overlap the illumination region 150 simultaneously. This allows the two objects 122, 132 (reticles MA) to be provided arbitrarily close to each other (for example in a scanning direction of the lithographic apparatus LA). This is advantageous as the available volume for reticle stages in lithographic apparatus (especially an EUV lithographic apparatus which uses reflective reticles) may be limited.

In some embodiments, the first object support 120 may be movable relative to the second object support 130 and/or the second object support 130 may be movable relative to the first object support 120 such that a relative position of the first and second object supports 120, 130 is controllable in 6 degrees of freedom. For example, these 6 degrees of freedom may comprise three translational degrees of freedom (x, y and z) and three rotational degrees of freedom (Rx, Ry, Rz).

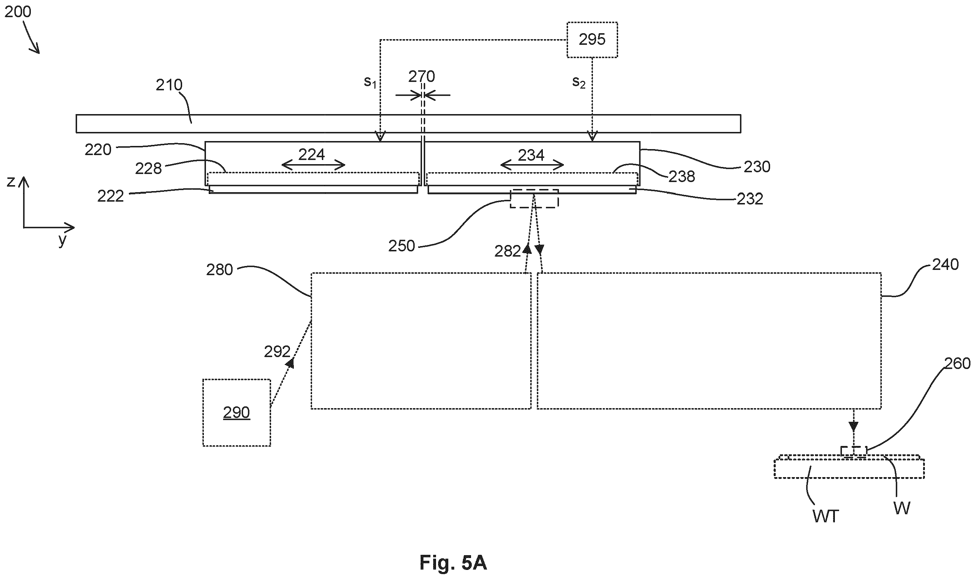

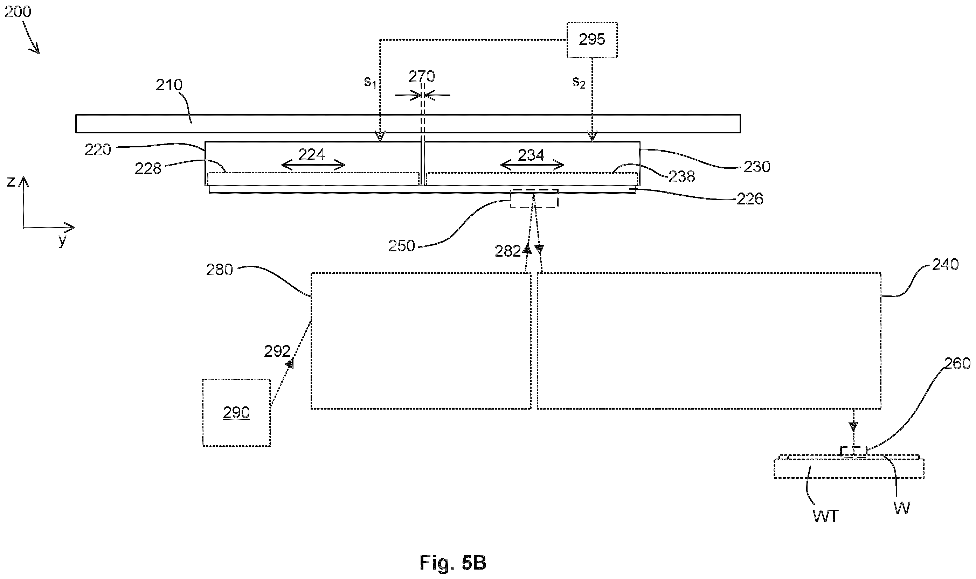

Figures 5A and 5B are schematic representations of a second exposure apparatus 200 according to an embodiment of the present disclosure. The second exposure apparatus 200 comprises: a main support 210; a first object support 220; and a second object support 230. The second exposure apparatus 200 comprises features that may be similar or identical to corresponding features of the exposure apparatus 100 shown in Figure 4. Features of the second exposure apparatus 200 which are generally equivalent to, or play a similar role to, features of the exposure apparatus 100 shown in Figure 4 have a reference numeral that is incremented by 100 relative to the reference numeral of the features of the exposure apparatus 100 shown in Figure 4. The second exposure apparatus 200 may comprise a lithographic apparatus LA of the type shown in Figure 1 or a part or sub-component of such a lithographic apparatus LA.

The main support 210 may be considered to be a static portion of the second exposure apparatus 200. For example, the main support 210 may comprise a frame which static parts of the second exposure apparatus 200 are connected to. Alternatively, the main support 210 may comprise a body which is connected to such a frame.

The first object support 220 is configured to support a first object 222 (see Figure 5A). As indicated by arrow 224, the first object support 220 is movable relative to the main support 210 so that the first object 222 is movable relative to a first illumination region 250. The first object 222 may comprise a reticle or mask MA. The first object support 220 may be generally of the form of a support structure MT (i.e. a reticle stage) of the type shown in Figure 1. The first illumination region 250 may be generally equivalent to the reticle-level or object-level illumination region IR described above with reference to Figure 1.

The second object support 230 is configured to support a second object 232 (see Figure 5B). As indicated by arrow 234, the second object support 230 is movable relative to the main support 210 so that the second object is movable relative to the first illumination region 250. The second object 232 may comprise a reticle or mask MA. The second object support 230 may be generally of the form of a support structure MT (i.e. a reticle stage) of the type shown in Figure 1.

The first object support 220 is offset from the second object support 230 in a first direction. In Figures 5A and 5B the first direction is labelled as the y-direction. As discussed further below, the first direction (y-direction) may be a scanning direction of the exposure apparatus 200. Note that, as indicated by arrows 124, 134, the first object support 220 and second object support 230 are each movable relative to the main support 110 in the first direction (y-direction). The first object support 220 and second object support 230 may also be movable relative to the main support 210 in a second direction that is perpendicular the first direction (y-direction).

A gap 270 between the first object support 220 and the second object support 230 is sufficiently small that a single object 226 (e.g. a single reticle MA) can be partially supported by the first object support 220 and partially supported by the second object support 230. Such an arrangement is shown in Figure 5B. For example, the single object 226 may have a dimension of the order of a factor of 2 greater than a dimension of existing reticles. For example, as opposed to a known 6"x6" reticle, the single object 226 may comprise a reticle having dimensions of the order of 12"x6".

The first object support 220 and/or the second object support 230 may be configured to support any type of patterning device MA (also referred to as a reticle or mask). The first object support 220 and/or the second object support 230 may comprise any type of reticle stage.

The second exposure apparatus 200 may comprise a lithographic apparatus (for example an EUV lithographic apparatus LA of the type shown in Figure 1). The second exposure apparatus 200 may be a scanning exposure apparatus. A lithographic apparatus LA may be used to form a pattern on a plurality of target regions 20 of a substrate W. For example, a lithographic apparatus LA may be used to form the same pattern on a plurality of target regions 20 (also referred to as fields) of a resist-coated silicon wafer W. The pattern is typically defined by a patterning device MA (also referred to as a reticle or mask). Radiation is patterned by the reticle MA and then imaging optics are used to form an image of the pattern on the wafer W. EUV lithographic reticles MA are reflective optical elements provided with a patterned coating that absorbs EUV radiation. The wafer W may then be moved and the image can be formed on another field 20 of the wafer W and so on. The pattern may be transferred to the wafer W during a scanning exposure in which the reticle MA is scanned through an illumination region IR (also referred to as a slit) while the wafer W is also moved such that the image of the reticle is stationary with respect to the wafer W.

The second exposure apparatus 200 is advantageous since it allows (a) for two separate objects 222, 233 (reticles) to be supported, one by each of the first and second object supports 220, 230 (see Figure 5A) or (b) a single object 226 (for example a larger than standard reticle) to be supported by the two object supports 220, 230 together (see Figure 5B). Therefore, the second exposure apparatus 200 provides a particularly versatile arrangement.

As with the exposure apparatus 100 shown in Figure 4, the first object support 220 may be offset from the second object support in a first direction (the y-direction in Figures 5A and 5B). As with the exposure apparatus 100 shown in Figure 4, the second exposure apparatus 200 may comprise imaging optics configured to form an image of the first illumination region 150 in a second illumination region. The imaging optics may be anamorphic such that a reduction factor of the image in the first direction may be greater than a reduction factor of the image in a second direction that is generally perpendicular to the first direction.

In some embodiments, the first object support 220 is movable relative to the second object support 230 and/or the second object support 230 is movable relative to the first object support 220 (similar to the functionality of the exposure apparatus 100 shown in Figure 4).

It will be appreciated that the exposure apparatus 100 shown in Figure 4 and the second exposure apparatus 200 shown in Figures 5A and 5B can be combined together. It will also be appreciated that optionally the exposure apparatus 100 shown in Figure 4 and/or the second exposure apparatus 200 shown in Figures 5A and 5B may comprise one or more optional features, as now discussed. In general, any features shown in dotted lines in Figures 4, 5A and 5B are optional features.

Optionally, as with the exposure apparatus 100 shown in Figure 4, the second exposure apparatus 200 may comprise imaging optics 240, which may be configured to form an image of the first illumination region 250 in a second illumination region 260. The imaging optics 240 may be generally analogous to the projection system PS shown in Figure 1 and as described above. The imaging optics 240 may also be anamorphic such that a reduction factor of the image in the first direction is greater than a reduction factor of the image in a second direction that is generally perpendicular to the first direction. In Figure 4 the second direction is into the page (and may be referred to as the x-direction).

The first object support 120, 220 and the second object support 130, 230 of the exposure apparatus 100, 200 may be provided such that a gap 170, 270 between them in a direction in which the first object support 120, 220 is offset from the second object support 130, 230 is less than 400 µm.

In some embodiments, the first object support 120, 220 and the second object support 130, 230 may be provided such that, in use, a gap between an imaging portion of a first object 122, 222 supported by the first object support 120, 220 and an imaging portion of a second object 132, 232 supported by the second object support 130, 230 in a direction in which the first object support 120, 220 is offset from the second object support 130, 230 is less than 400 µm.

The first and second objects 122, 222, 132, 232 define patterns that may contribute towards a device formed in the lithographic process. In addition to these patterns, the first object 122, 222 may also define some other features that are imaged by the lithographic process and, similarly, the second object 132, 232 may also define some other features that are imaged by the lithographic process. For example, the first and second objects 122, 222, 132, 232 may each also define various metrology marks and targets (for example overlay marks, electrical test structures etc.) which may be imaged onto the scribe lanes of the wafer W. The scribe lanes are the regions of the wafer that will be cut when the wafer W is divided into individual dies.

Typically the scribe lanes in a silicon wafer W that separate adjacent fields or target regions 20 have a dimension of the order of 50 µm on the wafer W. Therefore, with a reduction factor of 8 in the direction in which the first object support 120, 220 is offset from the second object support 130, 230, at reticle level the scribe lane between two adjacent fields 20 in this direction will be of the order of 400 µm. Therefore, by ensuring that an imaging portion of the first object 122, 222 and an imaging portion of the second object 132, 232 are provided such that a gap between them in the direction in which the first object support 120, 220 is offset from the second object support 130, 230 is less than 400 µm, the gap between the first and second objects can fall within a scribe lane.

The first object support 120, 220 may comprise an electrostatic clamp 128, 228. Similarly, the second object support 130, 230 comprises an electrostatic clamp 138, 238.

Optionally, the imaging optics 140, 240 may be configured such that a reduction factor of the image in the direction in which the first object support 120, 220 is offset from the second object support 130, 230 is 8 and a reduction factor of the image in a second direction that is generally perpendicular to the first direction is 4.

The exposure apparatus 100 and/or second exposure apparatus 200 may comprise illumination optics 180, 280 configured to illuminate with radiation 182, 282 the first illumination region 150, 250 through which an object supported by the first object support 120, 220 and/or the second object support 130, 230 can be moved. The illumination optics 140, 240 may be generally analogous to the illumination system IL shown in Figure 1 and as described above.

The exposure apparatus 100 and/or second exposure apparatus 200 may further comprise a radiation source 190, 290 operable to produce the radiation. For example, the radiation source 190, 290 may be operable to produce radiation 192, 292 which is received by the illumination optics 180, 280. The illumination optics 180, 280 may be operable to receive the radiation beam 192, 292 produced by the radiation source 190, 290 and to produce therefrom the radiation 182, 282 which illuminates the first illumination region 150, 250.

The radiation 192, 292 may comprise EUV radiation. The radiation source 190, 290 may comprise a laser-produced plasma (LPP) radiation source. For example, the radiation source 190, 290 may be generally of the form of to the radiation source SO shown in Figure 1 and as described above.

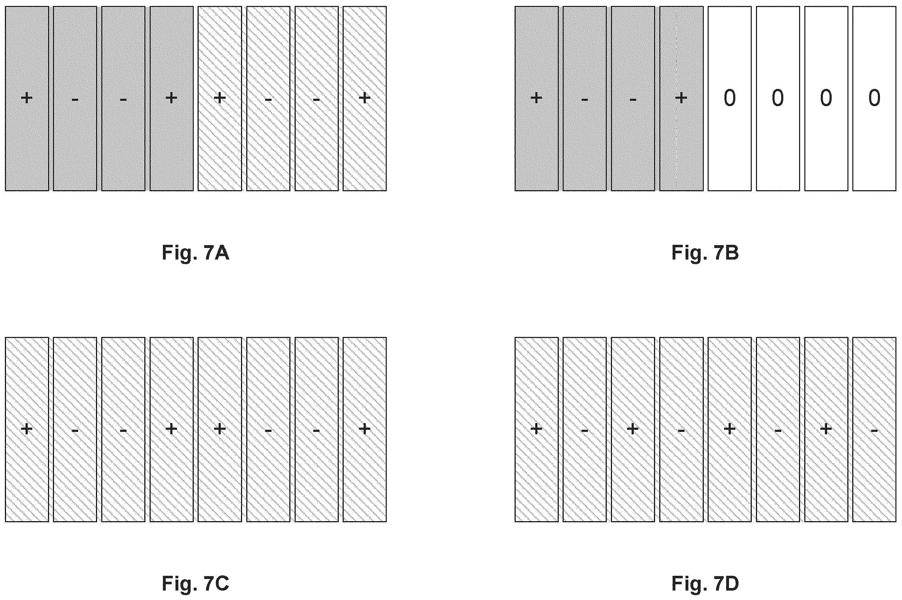

The exposure apparatus 100 and/or second exposure apparatus 200 may further comprise a controller 195, 295 operable to carry out any of the exposures methods described herein with reference to any one of Figures 7 to 9. The controller may, for example, be able to send one or more control signals s₁, s₂ so as to control, for example, a position of the first and second object supports 120, 130.

The exposure apparatus 100 and/or second exposure apparatus 200 may further comprise a substrate table WT configured to support a substrate W such that it is disposed in, and movable through, the second illumination region 160.

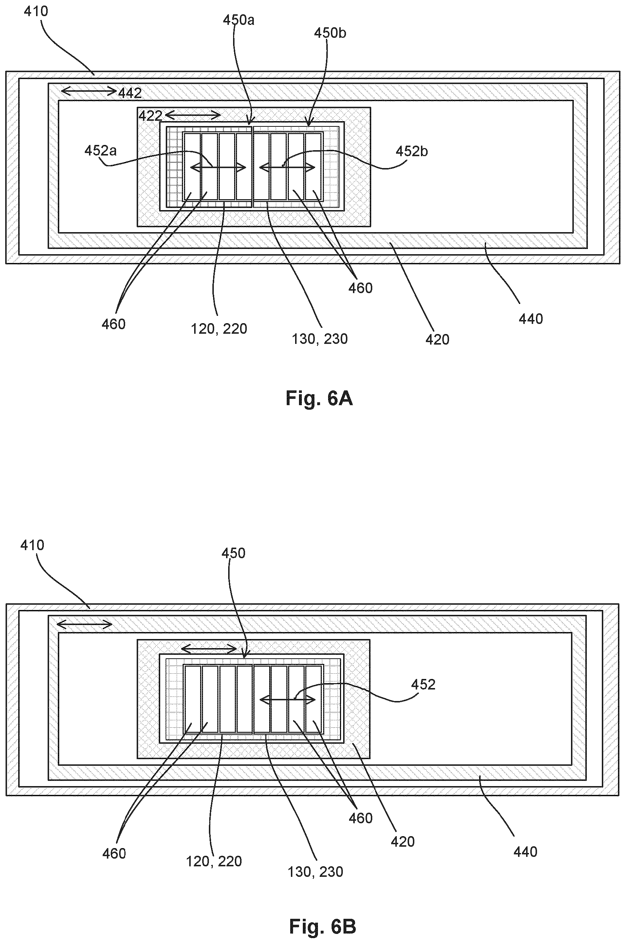

The exposure apparatus 100 and/or second exposure apparatus 200 may comprise a long stroke assembly 400 and/or at least one short stroke assembly 450, 450a, 450b, as now discussed with reference to Figures 6A and 6B. An embodiment comprising two short stroke assemblies 450a, 450b is shown in Figure 6A. An embodiment comprising one short stroke assembly 450 is shown in Figure 6B.

The long stroke assembly 400 may comprise a first portion 410 that is fixed relative to the main support 110, 210 and a second portion 420 that is movable relative to the first portion 410 (as indicated by arrow 422). The first portion 410 of the long stroke assembly 400 may comprise the main support 110, 210, a part of the main support 110, 210, or a member that is fixed to the main support 110, 210. The second portion 420 supports the first object support 120, 220 and the second object support 130, 230.

The coupling between the first and second portions 410, 420 of the long stroke assembly 400 (not shown) may comprise any suitable coupling which allows the second portion 420 to be movable relative to the first portion 410. For example, the coupling between the first and second portions 410, 420 of the long stroke assembly 400 may comprise a track and a motor operable to move the second portion 420 along the track and relative to the first portion 410, as is known in the art. The long stroke assembly 400 may allow for the first and second object supports 120, 220, 130, 230 to be moved relative to the first illumination region over distances of the order of 10s or 100s of millimetres.

The long stroke assembly 400 may further comprise at least one balance mass 440. The or each balance mass 440 may be movable relative to the first portion 410 of the long stroke assembly 400 (as indicated by arrow 442). In use, the or each balance mass 440 may move in an opposite sense to the first portion 410 of the long stroke assembly 400. When the second portion 420 of the long stroke assembly 400 accelerates relative to the first portion 410 of the long stroke assembly 400 it will exert reaction forces on the second portion 420 via the coupling between the first and second portions 410, 420 of the long stroke assembly 400. Although not shown there will be a coupling between the first portion of the long stroke assembly 400 and the or each balance mass 440. The or each balance mass 440 may be arranged and moved in such a way so as to also create reaction forces on the first portion 410 that at least partially cancel out the forces exerted by the second portion 420.

Each short stroke assembly 450, 450a, 450b comprises a first portion that is fixed relative to second portion 420 of the long stroke assembly 400 and a second portion that is movable relative to the first portion and which supports the first object support 120, 220 and/or the second object support 130, 230. That is, the second portion short stroke assembly 450, 450a, 450b is movable relative to the second portion 420 of the long stroke assembly 400, as indicated by arrows 452, 452a, 452b.

The coupling between the first portion and the second portion of each short stroke assembly 450, 450a, 450b (not shown) may comprise any suitable coupling which allows the second portion to be movable relative to the first portion. For example, the coupling may comprise any arrangement known in the art.

As shown in Figure 6A, some embodiments may comprise two short stroke assemblies 450a, 450b; a first short stroke 450a assembly may support the first object support 120, 220 and a second short stroke assembly 450b may support the second object support 130, 230. Such embodiments may comprise two clamps, each on a separate one of two short stroke assemblies 450a, 450b. The relative movement of the two clamps (for example in 6 degrees of freedom) may be achieved suing the two short stroke assemblies 450a, 450b, to achieve nanometer accurate positioning of one reticle with respect to the other. A gap between the two reticles can be made smaller than 400 µm. Such arrangements can support a single, larger (for example 12") reticle.

Alternatively, as shown in Figure 6B, in some other embodiments, two reticles may be supported by a single short stroke assembly 450 (either via the same or separate reticle clamps).

For embodiments of the type shown in Figure 6B and comprising two reticle clamps, at least one of the clamps may comprise actuators (for example piezoelectric actuators) configured to allow the first object support 120, 220 to be movable relative to the second object support 130, 230 (for example in 6 degrees of freedom). For such embodiments comprising two clamps on one short stroke 450 assembly, at least one of the two clamps can be adjusted (for example in 6 degrees of freedom) with respect to the other, to achieve nanometer accurate positioning of one reticle with respect to the other.

For embodiments of the type shown in Figure 6B and comprising one reticle clamp, a single glass structure may support the reticle(s). As explained above, this single glass structure may comprise a plurality of glass layers or plates, and a set of electrodes sandwiched between these glass layers. In particular, it may comprise a single plate or layer of glass (for example ultra-low expansion glass), which may define a plurality of protrusions or burls. For embodiments comprising a single reticle clamp, one set of burls and/or electrodes may be considered to form part of the first object support 120, 220 and another set of burls and/or electrodes may be considered to form part of the second object support 130, 230. For such embodiments, at least some of the burls may be provided with piezoelectric actuators in order to allow the first object support 120, 220 to be movable relative to the second object support 130, 230 (for example in 6 degrees of freedom). In principle the piezoelectric actuators could be provided on the burls. Alternatively, in one embodiment, the glass structure of the single clamp may comprise an additional layer, which could function as a piezoelectric layer to provide the adjustability to allow the first object support 120, 220 to be movable relative to the second object support 130, 230 (for example in 6 degrees of freedom). Alternatively, the clamp may comprise a flexure associated with the clamp which can allow for the first object support 120, 220 to be movable relative to the second object support 130, 230 (for example in 6 degrees of freedom).

It will be appreciated by the skilled person that the above mentioned description of the piezoelectric actuators in the burls or as an additional layer on the clamp and the clamp comprising a flexure for in 6 degrees of freedom is not limited alone to embodiment of Figure 6B but equally applicable to all the embodiments where 6 degrees of freedom control is required to move and align the first object with respect to the second object or vice versa.

With all of the above-described embodiments of the type shown in Figure 6B, a gap between the two reticles can be made smaller than 400 µm. Such arrangements can support a single, larger (for example 12") reticle.

Each of the first object support 120, 220 and the second object support 130, 230 may, in general, comprise an electrostatic clamp 128, 228, 138, 238. In both Figure 6A and 6B, each the first object support 120, 220 and the second object support 130, 230 are shown schematically as comprising four electrodes 460 (only some are labelled to improve the clarity of the Figures). It will be appreciated that other arrangements of electrodes may alternatively be used and this is merely an example. In general, to clamp a reticle typically a number of electrodes at a positive voltage is equal to a number of electrodes at a negative voltage.

Some examples of how these eight electrodes may be actuated for different arrangements of reticles are now discussed with reference to Figures 7A to 7D. It will be appreciated that different electrode configurations, and different polarity configurations, are also possible.

Figure 7A shows a possible actuation pattern for the electrodes of the arrangements shown in Figures 6A and 6B when the first and second object supports 120, 220, 130, 230 are each supporting a different object. Each set of four electrodes may be actuated as a pattern of positive, negative, negative, positive (+ - - +) or vice versa (- + + -). With such an arrangement the electrode from the first object support 120, 220 that is adjacent to the electrode from the second object support 130, 230 has the same polarity.

Figure 7B shows a possible actuation pattern for the electrodes of the arrangements shown in Figures 6A and 6B when only one of the first and second object supports 120, 220, 130, 230 is supporting an object (reticle). The arrangement is similar to that shown in Figure 7A although the voltage of all of the four electrodes of the object support that is not supporting an object are set to 0.

Figure 7C shows a first possible actuation pattern for the electrodes of the arrangements shown in Figures 6A and 6B when the first and second object supports 120, 220, 130, 230 are together supporting a single object (reticle). The arrangement is the same as that shown in Figure 7A.

Figure 7D shows a second possible actuation pattern for the electrodes of the arrangements shown in Figures 6A and 6B when the first and second object supports 120, 220, 130, 230 are together supporting a single object (reticle). The arrangement alternates between positive and negative polarities (i.e. either + - + - + - + - or - + - + - + - +).

Various new exposure methods and uses of the exposure apparatus 100 and/or second exposure apparatus 200 are now discussed.

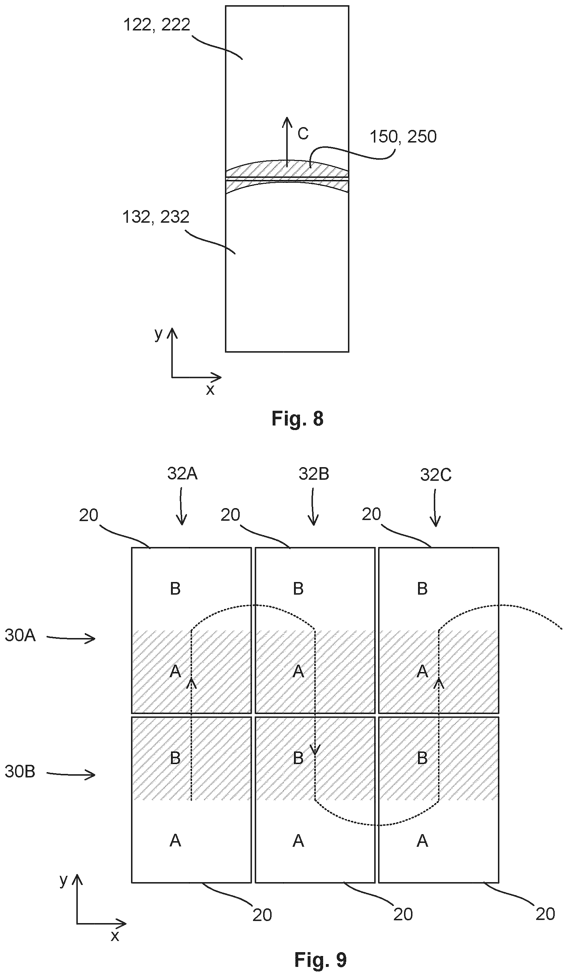

The exposure apparatus 100 and/or second exposure apparatus 200 allow for two different objects 122, 222, 132, 232 (reticles) to be provided within the exposure apparatus 100, 200. Furthermore, they allow for an arrangement wherein, for at least part of an exposure process, the two objects 122, 222, 132, 232 (reticles) can both partially overlap the first illumination region 150, 250 simultaneously. This is shown schematically in Figure 8, wherein the first illumination region 150, 250 is of a similar form to the reticle-level illumination region IR described above with reference to Figures 2A and 2B. A direction in which the first (reticle-level) illumination region 150, 250 effectively scans over the two objects 122, 222, 132, 232 is indicated by arrow C. It will be appreciated that, in practice this may be achieved by scanning the two objects 122, 222, 132, 232 through the first (reticle-level) illumination region 150, 250 in a direction opposite to the arrow C.

Therefore, with the exposure apparatus 100 and/or second exposure apparatus 200, rather than exposing two individual half fields during two different scans over the wafer W (with two different objects or reticles) two different objects 122, 222, 132, 232 (reticles) can be exposed during a single scanning exposure. One object 122, 222 is supported by the first object support 120, 220 and the other object 132, 232 is supported by the second object support 130, 230. One of the objects 122, 222 (reticles) is used to expose half of a first target region 20 or field and the other object 132, 232 (reticle) is used to expose half of an adjacent target region 20 or field. The two adjacent target regions 20 that are exposed are adjacent in the scanning direction of the exposure apparatus 100, 200 (i.e. the y-direction). The gap between the image regions of the two objects 122, 222, 132, 232 is matched to fall within a scribe line area of the wafer W between the two adjacent target regions 20. Therefore part of the scribe line areas that separate adjacent target regions 20 that are separated in the scanning direction (i.e. scribe lines that extend in a non-scanning direction or x-direction) may be provided with an exclusion zone which corresponds to the gap between the image portions of the two objects 122, 222, 132, 232 (reticles).

In some embodiments, an optional thin mask may be provided to control the radiation which is incident on the two objects 122, 222, 132, 232. The optional thin mask may take any convenient form. For example, the optional thin mask may comprise anything (for example reticle masking blades, opaque tape or a thin material made of a mask) that is arranged to shield the gap between the image regions of the two objects 122, 222, 132, 232 from the radiation.

Any flare impact of the edge of the two objects 122, 222, 132, 232 can be modelled in a software package.

An example exposure method is shown schematically in Figure 9, which shows six target regions 20 (solid line rectangles) arranged in a two-dimensional array of two rows 30A, 30B (extending in the non-scanning or x-direction) and three columns 32A, 32B, 32C (extending in the scanning or y-direction). Each target region 20 comprises two portions: a first portion (labelled A and on a lower half of the target regions 20 as shown in Figure 9); and a second portion (labelled B and on an upper half of the target regions 20 as shown in Figure 9).

Figure 9 illustrates a method during which, one object 122, 222 (reticles) is used to expose the first portion A of target regions from a first row 30A of target regions and another object 132, 232 (reticle) is used to expose the second portion B of target regions from a second row 30B of target regions 20. Within each column 32A, 32B, 32C of target regions, the first portion A from the first row 30A and the second portion B from the second row 30B are exposed during a single scanning exposure. Pairs of adjacent target regions 20 that are exposed during a single scanning exposure are adjacent in the scanning direction of the exposure apparatus 100, 200 (i.e. the y-direction). A path that the second (wafer-level) illumination region 160, 260, IR' scans over the wafer W is indicated by a dotted line (although it will be appreciated that in practice this scanning may be achieved by moving the wafer relative to the second illumination region 160, 260). The portions of the target regions that are being exposed as the second (wafer-level) illumination region 160, 260, IR' scans over the wafer W along the dotted line are shaded.

As shown in Figure 9, the exposure pattern may be similar to known meander scans except instead of a single target region 20, during each scanning exposure two portions of two adjacent target regions are exposed. As with known meander scans, two sequential exposures (which are exposing parts of the same two rows 30A, 30B of target regions) may use substantially opposite scan directions.

The arrangement shown in Figure 9 may form part of a meander scan which is similar to that shown Figure 3 and described above except, in general, instead of a single target region 20, during each scanning exposure two portions of two adjacent target regions are exposed. It will be appreciated that target regions adjacent to the edges of the wafer W exposures may be partially exposed by a scanning exposure using only one of the two objects 122, 222, 132, 232 (reticles).

Optionally the two images A, B formed on each target region 20 can be stitched together in the middle for dies with dimensions that exceed those of a half-field or to simply enhance the maximum field size used.

Optionally, the exposure apparatus 100 or second exposure apparatus 200 can be used to expose a single object 122, 222 to expose half fields at reduced throughput. This may be a particularly relevant option for small product sizes where the reticle cost dominates the total cost to produce dies. When operating in this way, the exposure apparatus 100 or second exposure apparatus 200 has an additional advantage in that in-between lot transitions, the object (reticle) for a new lot can be preloaded if its full field capability is not used, which can save some reticle exchange time.

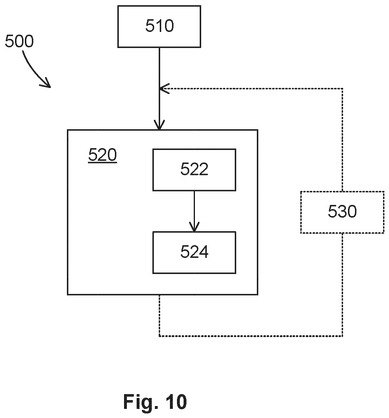

Some embodiments of the present disclosure relate to new exposure methods for forming a pattern on a plurality of target regions of a substrate W. Such new exposure methods may comprise any of the features discussed above with reference to Figures 8 and 9. An example, of such a new exposure method 500 forming a pattern on a plurality of target regions of a substrate W is now discussed with reference to Figure 10.

The exposure method 500 comprises a step 510 of providing a first object 122, 222 defining a first portion A of the pattern and a second object 132, 232 defining a second portion B of the pattern, such that the first object 122, 222 is adjacent to, and generally coplanar with, the second object 132, 232 and the first object 122, 222 is offset from the second object 132, 232 in a first direction (e.g. the y-direction or scanning direction).

The exposure method 500 further comprises at least one scanning exposure 520.

In turn, the or each scanning exposure 520 comprises a step 522 of moving the first object 122, 222 and the second object 132, 232 in the first direction such that they sequentially scan through a first illumination region IR, 150, 250 while providing radiation B, 182, 282 to the first illumination region IR, 150, 250.

The or each scanning exposure 520 further comprises a step 524 of capturing radiation scattered by the first and second objects 122, 222, 132, 232 and using it to form an image of the first and second objects 122, 222, 132, 232 in a second illumination region IR', 160, 260 while moving the substrate W through the second illumination region IR', 160, 260 such that an image of the first object 122, 222 is formed on a first target region of the substrate W and an image of the second object 132, 232 is formed on a second target region of the substrate W, the first and second target regions being mutually adjacent.

Note that although steps 522 and 524 are shown as separate steps it will be appreciated that in practice they will be performed substantially simultaneously. As will be appreciated by the skilled person, the first object 122, 222 and the second object 132, 232 are moved through the first illumination region IR, 150, 250 at the same time as the substrate W is moved through the second illumination region IR', 160, 260.

The exposure method 500 shown schematically in Figure 10 may be carried out using the exposure apparatus 100 shown in Figure 4 or the second exposure apparatus 200 shown in Figures 5A and 5B.

The exposure method 500 shown in Figure 10 may comprise a lithographic exposure method. The first object 122, 222 and the second object 132, 232 may comprise any type of patterning device MA (also referred to as a reticle or mask). The first illumination region IR, 150, 250 may be disposed in an object plane (which may also referred to as a reticle-level illumination region). The second illumination region IR', 160, 260 may be disposed in an image plane (which may also referred to as a wafer-level illumination region). The first and/or second illumination region may be referred to as a slit (or exposure slit).

Instead of exposing two half-fields separately as two different steps, with the exposure method 500 shown schematically in Figure 10 both reticles are exposed in a single stroke or scanning exposure. An image of the first object 122, 222 (reticle) is formed on a first target region (field) of the substrate W and an image of the second object 132, 232 (reticle) is formed on a second target region (field) of the substrate W, the first and second target regions being mutually adjacent. The area in-between these two images is matched to fall within the scribe line area of the wafer W.

In some embodiments of the method 500, the first object 122, 222 and the second object 132, 232 are provided such that a gap between them in the first direction is less than an extent of the first illumination region IR, 150, 250 in the first direction.

In some embodiments of the method 500, the first object 122, 222 and the second object 132, 232 are provided such that for at least a portion of the or each scanning exposure 520 the first and second objects 122, 222, 132, 232 are both partially disposed in the first illumination region IR, 150, 250 in the first direction.

In some embodiments of the method 500, the first object 122, 222 and the second object 132, 232 are provided such that a gap between them in the first direction is less than 400 µm.

In some embodiments of the method 500, the method 500 comprises a plurality of scanning exposures 520 and wherein the plurality of scanning exposures 520 are performed as a meander scan. For such embodiments, the method 500 may comprise a step 530 of moving the wafer W in between successive scanning exposures 520.

In some embodiments of the method 500, the method 500 may comprise a plurality of scanning exposures 520 and wherein the image A of the first object 122, 222 formed on a target region of the substrate W during one scanning exposure 520 is stitched to the image B of the second object 132, 232 formed on that target region of the substrate W during another scanning exposure 520.

In such embodiments of the method 500, the images A, B of the first object 122, 222 and the second object 132, 232 that are stitched may be mutually adjacent in the first direction. That is, the two images A, B that are stitched may be mutually adjacent in the scanning direction (y-direction). Put differently, a join line between the two images A, B that are stitched may extend in a second direction (a non-scanning direction or x-direction).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thinfilm magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An exposure apparatus comprising:
a main support;
a first object support configured to support a first object and movable relative to the main support so that the first object is movable relative to a first illumination region;
a second object support configured to support a second object and movable relative to the main support so that the second object is movable relative to the first illumination region; and
imaging optics configured to form an image of the first illumination region in a second illumination region;
wherein the first object support is movable relative to the second object support and/or the second object support is movable relative to the first object support;
wherein the first object support is offset from the second object support in a first direction; and
wherein the imaging optics is anamorphic such that a reduction factor of the image in the first direction is greater than a reduction factor of the image in a second direction that is generally perpendicular to the first direction.

2. The exposure apparatus of claim 1 wherein the first object support is movable relative to the second object support and/or the second object support is movable relative to the first object support such that a relative position of the first and second object supports is controllable in 6 degrees of freedom.

3. An exposure apparatus comprising:
a main support;
a first object support configured to support a first object and movable relative to the main support; and
a second object support configured to support a second object and movable relative to the main support;
wherein a gap between the first object support and the second object support is sufficiently small that a single object may be partially supported by the first object support and partially supported by the second object support.

4. The exposure apparatus of claim 3 wherein the first object support is movable relative to the second object support and/or the second object support is movable relative to the first object support.

5. The exposure apparatus of any preceding claim wherein the first object support and the second object support are provided such that a gap between them in a direction in which the first object support is offset from the second object support is less than 400 µm.

6. The exposure apparatus of any preceding claim wherein the first object support and/or the second object support comprises an electrostatic clamp.

7. The exposure apparatus of any preceding claim comprising a long stroke assembly comprising a first portion that is fixed relative to the main support and a second portion that is movable relative to the first portion and which supports the first object support and the second object support.

8. The exposure apparatus of claim 7 further comprising at least one short stroke assembly comprising a first portion that is fixed relative to second portion of the long stroke assembly and a second portion that is movable relative to the first portion which supports the first object support and/or the second object support.

9. The exposure apparatus of any preceding claim when not dependent either directly or indirectly on claim 1 further comprising imaging optics configured to form an image of a first illumination region in a second illumination region.

10. The exposure apparatus of any preceding claim when dependent either directly or indirectly on claim 1 or claim 9 wherein a reduction factor of the image in the direction in which the first object support is offset from the second object support is 8 and a reduction factor of the image in a second direction that is generally perpendicular to the first direction is 4.

11. The exposure apparatus of any preceding claim further comprising illumination optics configured to illuminate with radiation a first illumination region through which an object supported by the first object support and/or the second object support can be moved.

12. The exposure apparatus of claim 11 further comprising a radiation source operable to produce the radiation.

13. The exposure apparatus of any preceding claim further comprising a controller operable to carry out the exposure method of any one of claims 14 to 20.

14. An exposure method for forming a pattern on a plurality of target regions of a substrate, the exposure method comprising:
providing a first object defining a first portion of the pattern and a second object defining a second portion of the pattern, such that the first object is adjacent to, and generally coplanar with, the second object, the first object offset from the second object in a first direction; and
at least one scanning exposure, the or each scanning exposure comprising:
moving the first object and the second object in the first direction such that they sequentially scan through a first illumination region while providing radiation to the first illumination region; and
capturing radiation scattered by the first and second objects and using it to form an image of the first and second objects in a second illumination region while moving the substrate through the second illumination region such that an image of the first object is formed on a first target region of the substrate and an image of the second object is formed on a second target region of the substrate, the first and second target regions being mutually adjacent.

15. The method of claim 14 wherein the first object and the second object are provided such that a gap between them in the first direction is less than an extent of the first illumination region in the first direction.

16. The method of claim 14 or claim 15 wherein the first object and the second object are provided such that for at least a portion of the or each scanning exposure the first and second objects are both partially disposed in the first illumination region in the first direction.

17. The method of any one of claims 14 to 16 wherein the first object and the second object are provided such that a gap between them in the first direction is less than 400 µm.

18. The method of any one of claims 14 to 17 wherein the method comprises a plurality of scanning exposures and wherein the plurality of scanning exposures are performed as a meander scan.

19. The method of any one of claims 14 to 18 wherein the method comprises a plurality of scanning exposures and wherein the image of the first object formed on a target region of the substrate during one scanning exposure is stitched to the image of the second object formed on that target region of the substrate during another scanning exposure.

20. The method of claim 19 wherein images of the first object and the second object that are stitched are mutually adjacent in the first direction.
